# EUROPEAN PATENT APPLICATION

(11) **EP 1 622 436 A2**
(43) Date of publication of application: **01.02.2006**
(21) Application number: 05076530.4
(22) Date of filing: 05.07.2005
(51) Int. Cl.: H05K 3/34

(54) **Surface mount axial leaded component for an electronic module**

(30) Priority: 28.07.2004 US 900668
(71) Applicant: Delphi Technologies, Inc., Troy, MI 48007 (US)
(72) Inventor: Myers, Bruce A., Kokomo, IN 46901 (US); Degenkolb, Thomas A., Noblesville, IN 46060 (US)
(74) Representative: Denton, Michael John

(57) **Abstract**

A surface mountable axial leaded component (100) including a component body (102), a first component lead (104A) and a second component lead (104B). The first component lead (104A) extends from a first end of the component body (102) and a second component lead (104B) extends from a second end of the component body (102) that is opposite the first end. A portion of the first and second component leads (104A,104B) is formed in a loop and a diameter of the loop is at least equal to the diameter of the component body (102). The loop may be formed as a circular loop, an elliptical loop, a polygon loop, a square loop or rectangular loop, among other loop configurations. When formed as a circular loop, the loop may include a flat segment.

## Description

### Technical Field

The present invention is generally directed to an electronic module and, more specifically, to a surface mount axial leaded component for an electronic module.

### Background of the Invention

In general, electronic assemblies that have implemented relatively large surface mount components have experienced limited thermal cycle life in automotive applications, due to the failure of solder joints, which have attached the large surface mount components to conductive traces formed on a substrate. Typically, large surface mount components have been implemented within an electronic module when the components have been expected to dissipate a significant amount of power, e.g., greater than 0.5 watts, and carry significant current. While axial leaded components are capable of handling relatively high power and current levels, while providing a relatively long thermal cycle life, axial leaded components have typically been mounted to substrates as through-hole mounted components.

Unfortunately, the use of through-hole mounted axial leaded components has generally required an additional soldering process, e.g., a wave soldering process, which has added additional cost to the electronic module. While some higher current axial leaded components are commercially available with surface mount lead form designs, the designs of such components have been top heavy and, as such, are prone to fall over during assembly processes, and have also required correct orientation during component placement. A number of techniques have been implemented to address the thermal cycle reliability problem associated with large surface mount components. In general, these techniques have required removal of substrate material and/or use of additional components to provide stress relief for solder joints associated with the large surface mounted components. However, such techniques have also resulted in additional cost to the electronic module.

What is needed is a technique that addresses the thermal cycle reliability problem associated with large surface components that allows axial leaded components to be readily surface mounted.

### Summary of the Invention

Various embodiments of the present invention are directed to a surface mountable axial leaded component that includes a component body, a first component lead and a second component lead. The first component lead extends from a first end of the component body and a second component lead extends from a second end of the component body that is opposite the first end. A portion of the first and second component leads is formed in a loop and a diameter of the loop is at least equal to a diameter of the component body. The loop may be formed as a circular loop, an elliptical loop, a polygon loop, a square loop or rectangular loop, among other loop configurations. When formed as a circular loop, the loop may include a flat segment. According to a different aspect of the present invention, the diameter of the loop is greater than the diameter of the component body and the loop may be formed in a plane that is substantially orthogonal to a main axis of the component body. It should be appreciated that configuring the leads into loops provides stress relief for the component body, which decreases the stress applied to solder joints that attach the leads to conductive traces of an associated substrate, during thermal cycling.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
Fig. 1A is a side view of an exemplary surface mount axial leaded component constructed according to the present invention;
Fig. 1B is an end view of the component of Fig. 1A;
Fig. 2A is an end view of an exemplary surface mountable axial leaded component including a component body and a lead formed in an elliptical loop;
Fig. 2B is an end view of an exemplary surface mountable axial leaded component including a component body and a lead formed in a square or rectangular loop;
Fig. 2C is an end view of an exemplary surface mountable axial leaded component including a component body and a lead formed in a polygon loop;
Fig. 2D is an end view of an exemplary surface mountable axial leaded component including a component body and a lead formed in a circle with a flat segment; and
Fig. 3 is a portion of an exemplary electronic module including a substrate with a plurality of surface mount axial leaded components mounted thereto.

### Description of the Preferred Embodiments

The present invention is generally directed to an electronic module and, more specifically, an electronic module that includes one or more axial leaded components that have been modified and/or manufactured to be readily mounted as surface mount components. Advantageously, surface mount axial leaded components, configured according to the present invention, are lower in cost than standard surface mount components having the same current and power capabilities. In general, axial leaded components with leads configured according to the present invention are capable of handling higher power and current levels and have a longer thermal cycle life than traditional large surface mount components.

According to various embodiments of the present invention, the axial leads of a component may be formed in a variety of shapes, such as a circular, elliptical or segmented polygon configuration, that are symmetric to a component body. The leads of the component may be configured by wrapping an existing lead around a circular, elliptical or polygon-shaped mandrel. The diameter of a formed lead can be the same size or larger than a component body diameter to provide a desired stress relief and to achieve a desired footprint.

According to various embodiments of the present invention, a surface mount axial leaded component does not require specific rotational orientation and, as designed, provides substantially more stress relief during thermal cycles than standard surface mount components. As is mentioned above, the diameter of the leads can be increased to provide additional stress relief.

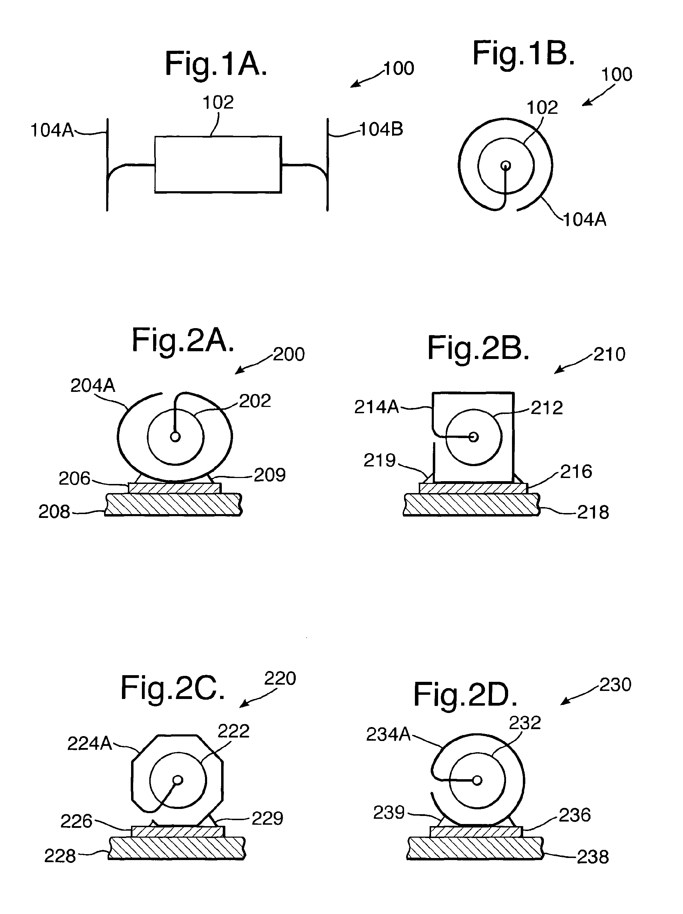

With reference to Fig. 1A, a side view of an exemplary surface mount axial leaded component 100 is depicted. As shown in Fig. 1A, the component 100 includes a component body 102, a first lead 104A extending from one end of the component body 102 and a second lead 104B extending from a second end of the component body 102. As is best shown in Fig. 1B, the lead 104A is formed in a circular loop that is, for example, slightly greater than the diameter of the component body 102. It should be appreciated that the component 100 may perform any number of electrical functions, such as providing a resistor, a diode, a varistor, a capacitor, etc.

With reference to Fig. 2A, a surface mountable axial leaded component 200, including a component body 202 and a lead 204A, formed in an elliptical loop, is shown positioned on a substrate 208 and attached to a conductive trace 206, which is formed on the substrate 208, with solder joint 209. As used herein, the term substrate includes all types of substrates typically utilized in electronic assemblies, e.g., printed circuit boards (PCBs) and ceramic substrates. Fig. 2B depicts a surface mountable axial leaded component 210 having a component body 212 and a lead 214A extending from the body 212. As is shown in Fig. 2B, the lead 214A is formed in a square or rectangular loop, with a portion of the loop contacting and joined, using solder joint 219, to a conductive trace 216 formed on a substrate 218. Referring to Fig. 2C, a surface mountable axial leaded component 220 includes a component body 222 having a lead 224A, extending from an end of the component body 222, formed as a polygon loop. A portion of the lead 224A is attached, with solder joint 229, to a conductive trace 226 formed on a substrate 228. Fig. 2D depicts a surface mountable axial leaded component 230 having a component body 232 and a lead 234A extending from an end of the body 232. As is shown, the lead 234A is formed in a circular loop with a flat segment, which is attached, with solder joint 239, to an electrical trace 236 formed on a substrate 238. It should be appreciated that each of the components 200, 210, 220 and 230 include a second lead extending from an end that is opposite the end shown.

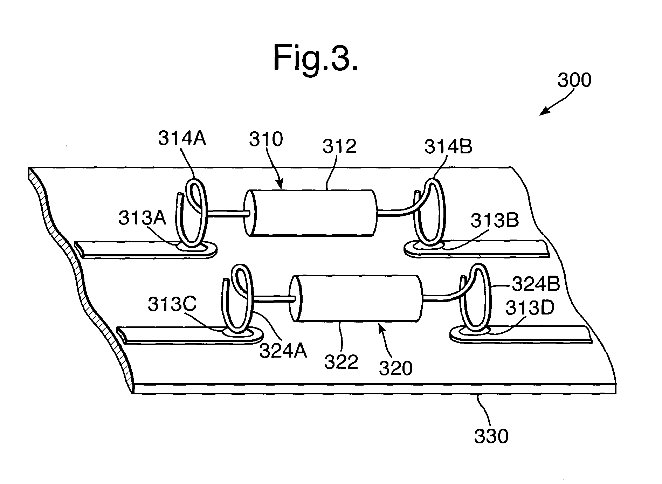

Fig. 3 depicts a portion of an electronic module 300 that includes a substrate 330, e.g., a printed circuit board (PCB), which has formed thereon a plurality of conductive traces. A surface mounted axial leaded component 320, e.g., a resistor, includes a component body 322 and a first lead 324A, extending from a first end of the body 322, and a second lead 324B, extending from a second end of the body 322, which is opposite the first end of the body 322. The leads 324A and 324B are coupled, by solder joints 313C and 313D, respectively, to associated traces formed on the substrate 330 and may take a variety of shapes, such as those shown in Figs. 1B, 2A-2D or, alternatively, take another form that provides stress relief. Another component 310, e.g., a diode, is shown coupled to electrical traces positioned on the substrate 330, by solder joints 313A and 313B. As is shown, the device 310 includes a device body 312, which has extending therefrom, at opposite ends, leads 314A and 314B. The leads 314A and 314B may also take a variety of forms, such as those shown in Figs. 1B and 2A-2D.

Accordingly, a surface mountable axial leaded component has been described herein that includes a plurality of leads, each of which are configured in a loop to readily allow for surface mounting of the axial leaded component and advantageously provide stress relief for the component body and its associated solder joints.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A surface mountable axial leaded component (100), comprising:
a component body (102); and
a first component lead (104A) extending from a first end of the component body (102) and a second component lead (104B) extending from a second end of the component body (102) that is opposite the first end of the component body (102), wherein a portion of the first and second component leads (104A,104B) is formed in a loop, and wherein a diameter of the loop is at least equal to a diameter of the component body (102).

2. The component (100) of claim 1, wherein the loop is a circular loop.

3. The component (100) of claim 1, wherein the loop is an elliptical loop.

4. The component (100) of claim 1, wherein the loop is a polygon loop.

5. The component (100) of claim 1, wherein the loop is a square loop.

6. The component (100) of claim 1, wherein the loop is a rectangular loop.

7. The component (100) of claim 1, wherein the loop is a circular loop with a flat segment.

8. The component (100) of claim 1, wherein the diameter of the loop is greater than the diameter of the component body (102).

9. The component (100) of claim 1, wherein the loop is formed in a plane that is substantially orthogonal to a main axis of the component body (102).

10. The component (100) of claim 1, wherein the loop provides stress relief for the component body (102).

11. An electronic module (300), comprising:
a substrate (330) including a plurality of electrically conductive traces formed on at least one surface of the substrate (330); and
at least one surface mountable axial leaded component (310) electrically coupled to at least two of the traces, the component (310) comprising:
a component body (312); and
a first component lead (314A) extending from a first end of the component body (312) and a second component lead (314B) extending from a second end of the component body (312) that is opposite the first end of the component body (312), wherein a portion of the first and second component leads (314A,314B) is formed in a loop, and wherein a diameter of the loop is at least equal to a diameter of the component body (312).

12. The module (300) of claim 11, wherein the loop is one of a circular loop, a circular loop with a flat segment, an elliptical loop, a polygon loop, a square loop and a rectangular loop.

13. The module (300) of claim 11, wherein the diameter of the loop is greater than the diameter of the component body (312).

14. The module (300) of claim 11, wherein the loop is formed in a plane that is substantially orthogonal to a main axis of the component body (312).

15. The module (300) of claim 11, wherein the loop provides stress relief for the component body (312).

16. The module (300) of claim 11, wherein the substrate (330) is a ceramic substrate.

17. The module (300) of claim 11, wherein the substrate (330) is a printed circuit board (PCB).

18. An electronic module (300), comprising:
a substrate (330) including a plurality of electrically conductive traces formed on at least one surface of the substrate (330); and
at least one surface mountable axial leaded component (310) electrically coupled to at least two of the traces, the component (310) comprising:
a component body (312); and
a first component lead (314A) extending from a first end of the component body (312) and a second component lead (314B) extending from a second end of the component body (312) that is opposite the first end of the component body (312), wherein a portion of the first and second component leads (314A,314B) is formed in a loop, and wherein a diameter of the loop is at least equal to a diameter of the component body (312) and the loop is one of a circular loop, a circular loop with a flat segment, an elliptical loop, a polygon loop, a square loop and a rectangular loop.

19. The module (300) of claim 18, wherein the diameter of the loop is greater than the diameter of the component body (312).

20. The module (300) of claim 19, wherein the loop is formed in a plane that is substantially orthogonal to a main axis of the component body (312).

21. The module (300) of claim 20, wherein the loop provides stress relief for the component body (312).

22. The module (300) of claim 21, wherein the substrate (330) is one of a ceramic substrate and a printed circuit board (PCB).
